(19)

Europäisches
Patentamt
European
Patent Office
Office européen
des brevets

(11) **EP 4 428 958 A1**

(12) **EUROPEAN PATENT APPLICATION**
published in accordance with Art. 153(4) EPC

(43) Date of publication:
**11.09.2024 Bulletin 2024/37**

(21) Application number: **22890406.6**

(22) Date of filing: **03.11.2022**

(51) International Patent Classification (IPC):
**H01M 8/0228** (2016.01)    **H01M 8/0206** (2016.01)
**H01M 8/0258** (2016.01)    **C25D 3/50** (2006.01)
**C25D 5/50** (2006.01)

(52) Cooperative Patent Classification (CPC):
**C25D 3/50; C25D 5/50; H01M 8/0206;**
**H01M 8/0228; H01M 8/0258;** Y02E 60/50;
Y02P 70/50

(86) International application number:
**PCT/KR2022/017131**

(87) International publication number:
**WO 2023/080675 (11.05.2023 Gazette 2023/19)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **04.11.2021 KR 20210150245**

(71) Applicant: **Hyundai Steel Company**
**Incheon 22525 (KR)**

(72) Inventors:
• **IM, Hyun Uk**
  **Incheon 22525 (KR)**

• **KIM, Kun Ho**
  **Incheon 22525 (KR)**
• **PARK, Kwang Seo**
  **Incheon 22525 (KR)**
• **LEE, Jae Ho**
  **Incheon 22525 (KR)**
• **JEONG, Yeon Soo**
  **Incheon 22525 (KR)**

(74) Representative: **Viering, Jentschura & Partner**
**mbB**
**Patent- und Rechtsanwälte**
**Am Brauhaus 8**
**01099 Dresden (DE)**

(54) **SEPARATOR, HAVING METAL COATING LAYER THEREON, FOR FUEL CELL AND MANUFACTURING METHOD THEREFOR**

(57)    A method for manufacturing a metal separator for a vehicle fuel cell according to an aspect of the present disclosure comprises the steps of: preparing a base material; applying a platinum (Pt)-containing coating agent and an electrolyte to the base material to form a discontinuous coating film; and thermally treating the coating film-formed base material.

[FIG. 1]

Processed by Luminess, 75001 PARIS (FR)

EP 4 428 958 A1

**Description**

[Technical Field]

The present disclosure relates to a separator for a fuel cell with metal coating layer and a manufacturing method therefor, and more particularly, to a separator for a fuel cell on which a discontinuous coating layer is formed, using platinum and precious metals, and a manufacturing method therefor.

[Background Art]

Fuel cells used in hydrogen electricity are utilized as a power source generating electricity through an electrochemical reaction between a reaction gas and a catalyst. A cell stack of the fuel cell has a structure in which components such as a membrane electrode assembly (MEA), a separator (or a bipolar plate), a gasket, a current collector, and an end plate are connected to each other. Among these components, the membrane electrode assembly (MEA) has a structure in which gas diffusion electrodes (GDEs) each including a catalyst layer and a gas diffusion layer (GDL) are in contact with both sides of a polymer electrolyte member with the polymer electrolyte membrane interposed therebetween.

A metal separator for a fuel cell is one of the components that constitute the stack of the fuel cell and is in electrical contact with a hydrogen electrode of a unit cell and an air electrode of an adjacent cell, where hydrogen and air are supplied into each electrode through a fluid flow channel on both sides of the separator. Therefore, the metal separator of a fuel cell collects and transmits electricity generated from electrochemical reactions, and plays a key role in conducting electricity, discharging water formed by electrical reactions, and managing heat inside a battery.

A material with excellent electrical conductivity, such as stainless steel, titanium alloy, aluminum alloy, or polymer composite material, is used as the base material of the separator. However, when the separator is exposed to an operating environment of the fuel cell for a vehicle in which a temperature and a humidity are high for a long time, due to characteristics of the metal, corrosion is accelerated, and metal oxide formed on a surface of the base material of the separator acts as an electrical insulator to decrease overall performance of the fuel cell due to decrease of conductivity or contamination of the catalyst.

In order to prevent these problems, research into technology of securing corrosion resistance and improving conductivity by forming a discontinuous coating layer containing a polymer, carbon, and various precious metal materials including gold (Au), platinum (Pt), ruthenium (Ru), iridium (Ir), etc., on the surface of the base material of the metal separator has been conducted, but in practice, a coating layer using a gold (Au) nano-coating layer has been mainly used. However, due to a continuous increase in price of gold (Au), the necessity to develop an alternative coating layer has emerged.

Furthermore, experiments or studies have previously been conducted showing that a discontinuous platinum (Pt) coating layer may be formed on a surface of the base material. However, the results showing process efficiency and clear significance in application of the coating layer using platinum are insufficient.

When the discontinuous coating layer is applied, a part of the surface of the base material of the separator is directly exposed to the outside. For future fuel cell stacks that require high output and long durability, coating technology with excellent conductivity and chemical stability is required even when used in harsh environments, despite the fact that a lot of resources are required to ensure performance due to coating uniformity of new coating materials and to verify the stability of a plated electrode body.

Related technology is disclosed in Korean Patent Laid-Open Publication No. 10-2015-0138105 (published on April 7, 2017, entitled "COATING COMPOSITION FOR METAL SEPARATOR OF SOLIDE OXIDE FUEL CELL AND PREPARATION METHOD THEREFOR").

[Disclosure]

[Technical Problem]

The problem to be solved by the present disclosure is to provide a metal separator of a fuel cell for a vehicle with excellent corrosion resistance and contact resistance, as well as excellent production efficiency, and a manufacturing method therefor.

[Technical Solution]

A method for manufacturing a metal separator of a fuel cell for a vehicle according to one embodiment of the present disclosure may include the steps of: preparing a base material; forming a discontinuous coating layer by applying coating agent that contains platinum (Pt) and further contains at least one of the groups consisting of gold (Au), ruthenium (Ru), iridium (Ir), ruthenium oxide ($RuO_2$), and iridium oxide ($IrO_2$), and an electrolyte to the base material; and thermally treating the base material on which the coating layer is formed.

In an embodiment, the base material may be a stainless steel plate, titanium, or aluminum.

In an embodiment, the step of forming of the coating layer may be performed through any one of electroplating, electroless plating, or a PVD process.

In an embodiment, chloroplatinic acid ($H_2PtCl_6$) or potassium chloroplatinate ($K_2PtCl_6$) may be contained as platinum (Pt) contained in the coating agent.

In an embodiment, the step of thermally treating may be performed in a temperature range of 80 to 600°C and a time range of 10 to 180 minutes.

In an embodiment, the step of thermally treating may be performed under any one of vacuum, air, and oxygen atmosphere.

The metal separator of a fuel cell for a vehicle according to another embodiment of the present disclosure may be a metal separator of a fuel cell for a vehicle manufactured by any one of the above-described embodiments.

[Advantageous Effects]

According to the present disclosure, a metal separator for a fuel cell with excellent corrosion resistance and contact resistance, as well as excellent production efficiency, and a manufacturing method therefor may be provided.

[Description of Drawings]

FIG. 1 is a process flow diagram schematically illustrating a method for manufacturing a separator for a fuel cell according to an embodiment of the present disclosure.

FIG. 2 is a diagram schematically illustrating a step of coating platinum according to an Example of the present disclosure and Comparative Example.

FIG. 3 is a diagram schematically illustrating a step of thermal treatment according to an Example of the present disclosure and Comparative Example.

FIG. 4 is a schematic diagram for explaining specimens and measurement positions for measuring contact resistance of Examples and Comparative Examples of the present disclosure.

[Best Mode]

Hereinafter, the present disclosure will be described in detail to enable those skilled in the art to which the invention belongs to readily practice the invention with reference to the accompanying drawings. The present disclosure may be implemented in many different forms and is not limited to the embodiments described herein. Throughout the specification, identical or similar components are indicated by the same reference numerals. In addition, detailed descriptions of known functions and configurations that may unnecessarily obscure the gist of the present disclosure are omitted.

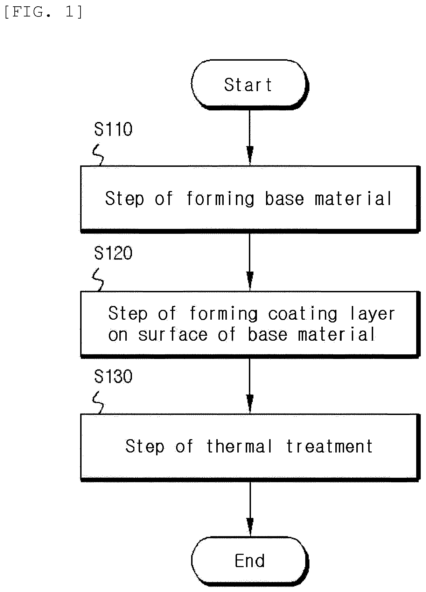

FIG. 1 is a flow diagram used in a method for manufacturing of a metal separator of a fuel cell for a vehicle according to an embodiment of the present disclosure. The manufacturing method according to the present disclosure includes a step of forming base material (S110), a step of forming coating layer on a surface of base material (S120), and a step of thermal treatment (S130).

Step of forming base material (S110)

There is no particular limitation on the steel of the metal separator of a fuel cell for a vehicle as long as it is a metal or non-ferrous metal used for the metal separator, but stainless steel, titanium, aluminum, etc. may be used, and for example, SUS 300-series and 400-series stainless steel or Grade 1 titanium may be preferred due to their superior elongation properties and durability.

**Step of forming coating layer on surface of base material (S120)**

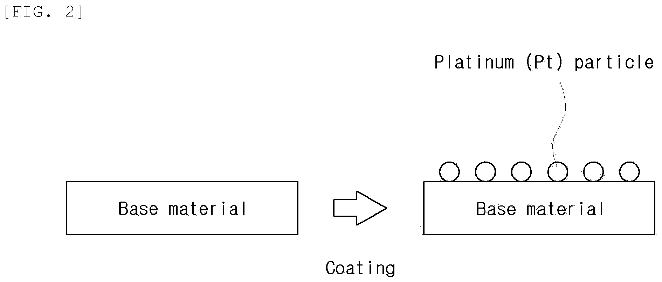

FIG. 2 schematically illustrates of a step of forming a coating layer containing discontinuous platinum on a surface of the base material.

When the fuel cell for a vehicle is exposed to a high-temperature and humid operating environment for an extended period of time, metal oxides that gradually adversely affect the conductivity of the fuel cell form on the surface of the base material. Therefore, in the present disclosure, a discontinuous coating layer is formed on the surface of the base material to enhance the fuel cell's corrosion resistance and conductivity.

In order to form a coating layer with both excellent corrosion resistance and conductivity, a range of precious metals including gold (Au), platinum (Pt), ruthenium (Ru), and iridium (Ir) are typically used. The present disclosure may form a coating layer of a metal separator of a fuel cell of for a vehicle with excellent corrosion resistance and conductivity by forming a coating layer containing platinum (Pt) on the surface of the base material, according to the purpose.

Specifically, in the step of forming a coating layer, a coating layer is formed by applying a current at a constant coating temperature using a coating material and an electrolyte. The coating material may be used without limitation as long as it contains platinum (Pt) and may be used as a coating material, but in particular, chloroplatinic acid ($H_2PtCl_6$) or potassium chloroplatinate ($K_2PtCl_6$) is preferred for a stable and efficient process.

Platinum (Pt) and additional noble metal-based coating materials used as coating materials may be nanoparticles having a size of 10 nm to 1 um, and in the above range, these materials may form a discontinuous coating layer of lower density on the surface of the base material.

As an electrolyte, an acidic electrolyte, for example, a sulfuric acid-based or hydrochloric acid-based electrolyte may be used, and in particular, $H_2SO_4$ or $HClO_4$ is preferred in terms of efficient chemical reaction during the formation of the platinum coating layer of the process.

The content of the coating material and electrolyte may vary depending on the amount of Pt deposited and coating density required according to the specific embodiment. However, for example, a mixture of chloroplatinic acid ($H_2PtCl_6$) or potassium chloroplatinate ($K_2PtCl_6$) in the rang e of $1 \times 10^{-4}$ to 1 M and perchloric acid ($HClO_4$) or sulfuric acid ($H_2SO_4$) in the range of $1 \times 10^{-2}$ to 1 M may be used. In particular, corrosion performance and contact resistance may be excellent when chloroplatinic acid ($H_2PtCl_6$) or potassium chloroplatinate ($K_2PtCl_6$) in the range of 2 mM to 0.1 M and perchloric acid (HClO) or sulfuric acid ($H_2SO_4$) in the range of 0.1 M to 0.5 M are used. It is more preferable when chloroplatinic acid ($H_2PtCl_6$) or potassium chloroplatinate ($K_2PtCl_6$) in the range of 10 mM to 0.05 M and perchloric acid (HClO) or sulfuric acid ($H_2SO_4$) in the range of 0.2 M to 0.3 M are used.

If the relative content of the coating material and the electrolyte within the above range is 1 to 10 times the unit molar content of the electrolyte, a coating layer with excellent corrosion performance and contact resistance may be formed. If the content is less than the above range, sufficient platinum (Pt) coating may not be achieved. Conversely, exceeding this range could lead to a decrease in the process's efficiency.

When chloroplatinic acid ($H_2PtCl_6$) or potassium chloroplatinate ($K_2PtCl_6$) as a coating material is used in the range of less than $5 \times 10^{-3}$, it may be difficult to secure a sufficient amount of platinum (Pt) deposited. When the electrolyte is used in the range of less than $5 \times 10^{-3}$, it may be difficult to secure sufficient reduction.

As a coating material, in addition to chloroplatinic acid or potassium chloroplatinate containing platinum, a coating material composed of precious metal-based components such as gold (Au), ruthenium (Ru), iridium (Ir), ruthenium oxide ($RuO_2$), and iridium oxide ($IrO_2$) may be additionally used. When an additional coating material is used, in addition to the sulfuric acid-based or hydrochloric acid-based electrolyte, a hydrofluoric acid-based or sulfuric acid-based electrolyte may be additionally used depending on the chemical properties of the added material.

The coating step may be performed even in a coating temperature of room temperature, but may be performed in the range of, for example, 25 to 80°C in that reactivity may be improved through heating. Particularly, when the coating step is performed in the range of 40 to 60°C, corrosion performance and contact resistance are excellent while considering efficiency of a process, and particularly when the coating step is performed in the range of 50°C to 60°C, corrosion performance and contact resistance are excellent.

It is preferably to perform the applied current during coating in the range of 5 to 60 mA/cm$^2$ in order to suppress uncoating or overcoating in an amount of platinum (Pt) deposited and to prevent surface oxidation due to overcurrent. In particular, for optimal surface stability of the base material and superior coating layer performance, it is preferable to perform in the range of 10 to 20 mA/cm$^2$.

The base material surface coating process method is not particularly limited as long as it is a commonly used method, but may be selected from, for example, electroplating, electroless plating, or a PVD method, and utilizing these methods can enhance the efficiency of the process. Particularly, electroplating is desirable for its ability to produce uniform coating properties and mass production in coating and manufacturing a separator cathode.

## Step of thermal treatment (S130)

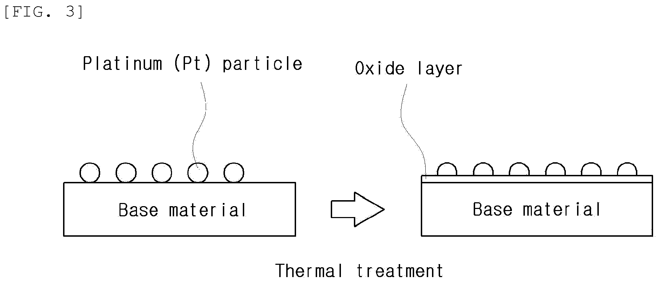

FIG. 3 schematically illustrates a step of thermal treatment of a base material on which the coating layer is formed.

In the step of coating a surface of a base material, since a discontinuous coating layer of platinum (Pt) and other materials is formed on the surface of the base material to expose part of the surface of the base material to the outside, a step of forming oxide layer (S130) is performed through a thermal treatment process to secure excellent corrosion current and contact resistance throughout the separator.

Specifically, the temperature of the thermal treatment process may vary depending on the oxide layer formation characteristics of the base material, but it may be performed, for example, in a temperature range of 80 to 600°C. In particular, in the temperature range of 170 to 230°C for a stainless steel base material and 300 to 500°C for a titanium base material, the oxide layer formation rate and oxide layer efficiency are excellent.

The time of the thermal treatment process may also vary depending on the characteristics of the base material. However, thermal treatment process may be performed, for example, for 10 to 180 minutes, and particularly, when performed for 30 to 60 minutes, the corrosion current and contact resistance performances of the oxide layer are excellent.

The thermal treatment process may be performed in a standard atmosphere, but when performed in a low-oxygen, vacuum, or nitrogen atmosphere, the oxide layer formation efficiency and the formed oxide layer performance may be improved. Specifically, performing the thermal treatment in a low-oxygen atmosphere is advantageous as it helps prevent the excessive formation of oxide layers, thereby ensuring optimal contact resistance and maintaining the adhesion quality of the coating.

## Metal separator of fuel cell for vehicle

According to the method of manufacturing the metal separator of a fuel cell for a vehicle, the metal separator of the fuel cell may have excellent corrosion resistance and electrical conductivity for an extended period of time even in a high temperature and high humidity operating environment.

Therefore, as described above, the metal separator of a fuel cell for a vehicle with excellent corrosion resistance and electrical conductivity may be subjected to a base material coating step using a coating material containing platinum (Pt) and an electrolyte and a thermal treatment step to complete the metal separator of a fuel cell for a vehicle in which a base material, a discontinuous coating layer on its surface, and an oxide layer on a part where the coating layer is not formed are formed.

## Examples and Comparative Examples

A base material forming step with the base material, coating material and electrolyte compositions, applied currents, and temperatures as shown in Table 1 below and a coating step were performed, and a thermal treatment step was performed on the base material on which the discontinuous coating layer was formed under the conditions in Table 2 to manufacture specimens of Examples and Comparative Examples, respectively.

Specifically, when compared to the Examples according to the present disclosure, in the coating material formation step, metal separator specimens were manufactured by changing the amount of coating material in Comparative Example 1, the amount of electrolyte in Comparative Example 5, and the applied currents in Comparative Examples 2 and 6, respectively, as shown in Table 1, and in the thermal treatment step, by changing the heat treatment time in Comparative Examples 3 and 6, and the heat treatment temperature in Comparative Examples 4 and 8, respectively as shown in Table 2.

[table 1]

| Category | Base material | Coating material (M) | Electrolyte (M) | Applied current (mA/cm$^2$) | Temperature (°C) |
|---|---|---|---|---|---|
| Example 1 | SUS316L | 0.1 H$_2$PtCl$_6$ | 0.1 HClO$_4$ | 10 | 60 |
| Example 2 | | 0.1 H$_2$PtCl$_6$ | 0.1 HClO$_4$ | 20 | 60 |
| Example 3 | | 0.05 H$_2$PtCl$_6$ | 0.5 H$_2$SO$_4$ | 10 | 60 |
| Example 4 | | 0.02 K$_2$PtCl$_6$ | 0.1 HClO$_4$ | 20 | 40 |
| Example 5 | | 0.02 K$_2$PtCl$_6$ | 0.5 H$_2$SO$_4$ | 30 | 40 |
| Comp. Example 1 | | 5×10$^{-5}$ H$_2$PtCl$_6$ | 0.5 H$_2$SO$_4$ | 10 | 60 |
| Comp. Example 2 | | 0.1 H$_2$PtCl$_6$ | 0.1 HClO$_4$ | 3 | 60 |
| Comp. Example 3 | | 0.1 H$_2$PtCl$_6$ | 0.1 HClO$_4$ | 20 | 50 |
| Comp. Example 4 | | 0.1 H$_2$PtCl$_6$ | 0.1 HClO$_4$ | 20 | 60 |
| Example 6 | Ti grade 1 | 0.1 H$_2$PtCl$_6$ | 0.1 HClO$_4$ | 10 | 60 |
| Example 7 | | 0.1 H$_2$PtCl$_6$ | 0.1 HClO$_4$ | 20 | 60 |
| Example 8 | | 0.05 H$_2$PtCl$_6$ | 0.5 H$_2$SO$_4$ | 10 | 60 |
| Example 9 | | 0.02 K$_2$PtCl$_6$ | 0.1 HClO$_4$ | 20 | 40 |
| Example 10 | | 0.02 K$_2$PtCl$_6$ | 0.5 H$_2$SO$_4$ | 30 | 40 |
| Comp. Example 5 | | 0.1 H$_2$PtCl$_6$ | 0.05 HClO$_4$ | 20 | 60 |
| Comp. Example 6 | | 0.1 H$_2$PtCl$_6$ | 0.1 HClO$_4$ | 3 | 60 |
| Comp. Example 7 | | 0.1 H$_2$PtCl$_6$ | 0.1 HClO$_4$ | 20 | 60 |
| Comp. Example 8 | | 0.1 H$_2$PtCl$_6$ | 0.1 HClO$_4$ | 20 | 60 |

[Table 2]

| Category | Thermal treatment temperature (°C) | Thermal treatment time (min) |
|---|---|---|
| Example 1 | 190 | 60 |
| Example 2 | 200 | 60 |
| Example 3 | 210 | 60 |
| Example 4 | 220 | 50 |
| Example 5 | 230 | 40 |
| Comp. Example 1 | 210 | 60 |
| Comp. Example 2 | 220 | 60 |
| Comp. Example 3 | 220 | 120 |
| Comp. Example 4 | 150 | 60 |

(continued)

| Category | Thermal treatment temperature (°C) | Thermal treatment time (min) |
|---|---|---|
| Example 6 | 350 | 60 |
| Example 7 | 350 | 40 |
| Example 8 | 450 | 60 |
| Example 9 | 450 | 40 |
| Example 10 | 350 | 60 |
| Comp. Example 5 | 350 | 60 |
| Comp. Example 6 | 450 | 60 |
| Comp. Example 7 | 350 | 120 |
| Comp. Example 8 | 250 | 60 |

**Contact resistance measurement**

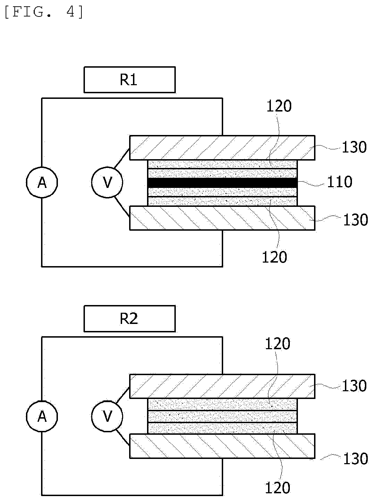

Interfacial contact resistance (ICR) was measured for Examples and Comparative Examples. FIG. 4 is a schematic diagram illustrating a structure of specimens for measuring the contact resistance of a metal separator of a fuel cell for a vehicle according to the present disclosure, and measurement positions of a comparative specimen (dummy). Prior to actual measurement, two gas diffusion layers (GDL) (120) and one current collector (130) were formed on both sides of the metal separator (bipolar plate: bp) (110) of each Comparative Example and Example to manufacture a specimen, and then the contact resistance between the separator and the gas diffusion layer (GDL) was measured at two points R1 and R2 and calculated according to the following equation to calculate the resistance between the separation and the gas diffusion layer. For R2 measurement, three gas diffusion layers (120) were stacked except for the metal separator, and a current collector (130) was stacked on both sides to manufacture a dummy specimen, and then, a pressure of 50 to 100 N/cm$^2$ was applied to the dummy using a pressure machine (68SC5, Instron Corporation) when measuring contact resistance.

$$R1 = 2R_{cc-GDL} + 2R_{GDL-GDL} + 2R_{bp-GDL}$$

$$R2 = 2R_{cc-GDL} + 2R_{GDL-GDL}$$

$$R_{bp-GDL} = (R1 - R2)/2$$

$$ICR = R_{bp-GDL} \times S$$

wherein bp refers to a metal separator, GDL refers to a gas diffusion layer, cc refers to a current collector, and S refers to a separator-GDL reaction area.

**Corrosion performance measurement**

Specimens were manufactured from the metal separators of the above Examples and Comparative Examples, and short-term corrosion resistance evaluation of the base material and surface treatment layer was performed on each specimen. A potentiodynamic polarization method was conducted, and the test conditions are shown in Table 3 below. HIOKI's 3541 precision resistance measurement equipment was used as the current application and resistance measurement equipment.

[Table 3]

| Category | Description |
|---|---|
| Corrosive solution | 0.1 N $H_2SO_4$ + 2 ppm HF |
| Solution temperature | Maintained at 80° C |
| Working electrode Exposed area | 1.0 $cm^2$ |
| Reference electrode | Mercury sulfate electrode (MSE) SCE (@0.6V vs SCE) |
| Counter electrode | Carbon electrode rod |
| Scan Rate | 1 mV/s |
| Scan Range | -0.25 V vs. OCV ~ 1.0 V |
| Evaluation standard | 10 $\mu A/cm^2$ or less |

The results of the interfacial contact resistance and corrosion performance measured as above are shown in Table 4 below.

[Table 4]

| Category | Interfacial contact resistance ($m\Omega \cdot cm^2$) | Corrosion performance ($\mu A/cm^2$) |
|---|---|---|
| Example 1 | 8.3 | 2.5 |
| Example 2 | 9.7 | 1.8 |
| Example 3 | 9.9 | 1.5 |
| Example 4 | 8.9 | 1.9 |
| Example 5 | 9.8 | 1.3 |
| Comp. Example 1 | 20.1 | 3.3 |
| Comp. Example 2 | 28.2 | 1.2 |
| Comp. Example 3 | 42.9 | 0.8 |
| Comp. Example 4 | 7.8 | 13.1 |
| Example 6 | 11.2 | 2.2 |
| Example 7 | 9.3 | 2.4 |
| Example 8 | 12.6 | 0.8 |
| Example 9 | 11.7 | 1.2 |
| Example 10 | 10.6 | 2.5 |
| Comp. Example 5 | 18.6 | 4.5 |
| Comp. Example 6 | 33.2 | 3.1 |
| Comp. Example 7 | 38.5 | 0.7 |
| Comp. Example 8 | 9.8 | 11.1 |

For Comparative Examples and Examples, a steering rack bar was manufactured to perform a cold drawing test, and the product was visually observed for cracks occurred and the results are shown in Table 4.

Referring to Tables 1 to 4, in Examples 1 to 5 and Comparative Examples 1 to 4 using a stainless base material and Examples 6 to 10 and Comparative Examples 5 to 8 using a titanium base material, each Example was found to be excellent in terms of corrosion performance and interfacial contact resistance compared to the Comparative Examples.

Specifically, it was confirmed that when the amount of electrolyte or coating material was out of the range of the present disclosure, the performance was significantly degraded compared to other Examples using the same base material in terms of both interfacial contact resistance and corrosion performance, and it was confirmed that when the applied current and coating temperature are out of a certain range, the performance of the interfacial contact resistance was degraded, which means that appropriate coating process conditions have a significant impact on achieving the purpose of the present disclosure.

Even in the step of thermal treatment, it was found that the thermal treatment temperature and thermal treatment time had an effect on the interfacial contact resistance and corrosion performance, respectively. In particular, it was confirmed that the thermal treatment time had a significant effect in terms of interfacial contact resistance, and the thermal treatment temperature had a significant effect in terms of corrosion performance.

Although the above description focuses on the embodiments of the present disclosure, various changes and modifications can be made at the level of those skilled in the art. It can be said that these changes and modifications belong to the present disclosure as long as they do not depart from the scope of the present disclosure. Therefore, the scope of the present disclosure should be determined by the claims set forth below.

[Industrial Applicability]

The present disclosure may be utilized in the field of fuel cells and in the field of separators for a fuel cells, and can improve the reliability and competitiveness of products in these fields.

**Claims**

1. A method for manufacturing a metal separator of a fuel cell for a vehicle_the method comprising steps of:

    preparing a base material;
    forming a discontinuous coating layer by applying a platinum (Pt)-containing coating agent and an electrolyte to the base material; and
    thermally treating the base material on which the coating layer is formed.

2. The method of claim 1, wherein the coating agent further contains at least one of the groups consisting of gold (Au), ruthenium (Ru), iridium (Ir), ruthenium oxide ($RuO_2$), and iridium oxide ($IrO_2$).

3. The method of claim 1, wherein the base material is stainless steel plate, titanium, or aluminum.

4. The method of claim 1, wherein the step of forming the coating layer is performed through any one of electroplating, electroless plating, or a PVD process.

5. The method of claim 1, wherein chloroplatinic acid ($H_2PtCl_6$) or potassium chloroplatinate ($K_2PtCl_6$) is contained as platinum (Pt) contained in the coating agent.

6. The method of claim 1, wherein the step of thermally treating is performed in a temperature range of 80 to 600°C and a time range of 10 to 180 minutes.

7. The method of claim 1, wherein the step of thermally treating is performed under any one of vacuum, air, and oxygen atmosphere.

8. A metal separator of a fuel cell for a vehicle manufactured by the method of any one of claims 1 to 7.

[FIG. 1]

[FIG. 2]

Platinum (Pt) particle

Base material

Coating

Base material

[FIG. 3]

Platinum (Pt) particle          Oxide layer

Base material          ⇨          Base material

Thermal treatment

[FIG. 4]

## INTERNATIONAL SEARCH REPORT

| International application No. |
|---|
| **PCT/KR2022/017131** |

**A. CLASSIFICATION OF SUBJECT MATTER**

**H01M 8/0228**(2016.01)i; **H01M 8/0206**(2016.01)i; **H01M 8/0258**(2016.01)i; **C25D 3/50**(2006.01)i; **C25D 5/50**(2006.01)i

According to International Patent Classification (IPC) or to both national classification and IPC

**B. FIELDS SEARCHED**

Minimum documentation searched (classification system followed by classification symbols)

H01M 8/0228(2016.01); C23C 14/58(2006.01); H01M 8/02(2006.01); H01M 8/04(2006.01); H01M 8/10(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 연료전지(fuel cell), 금속(metal), 스테인리스(stainless), 분리판(separator, bipolar plate), 차량(automobile), 코팅(coating), 백금(platinum), 도금(plating), 불연속성(discontinuity), 열처리(heating), 진공(vacuum)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2011-0020106 A (HYUNDAI HYSCO CO., LTD.) 02 March 2011 (2011-03-02)<br>See paragraphs [0022]-[0034], [0040]-[0042], [0044] and [0046]; and figures 1-4. | 1-8 |
| Y | KR 10-0964131 B1 (FURUYA METAL CO., LTD.) 16 June 2010 (2010-06-16)<br>See paragraphs [0004], [0026], [0027], [0053]-[0071], [0118] and [0172]-[0176]. | 1-8 |
| A | KR 10-2013-0124071 A (KNU-INDUSTRY COOPERATION FOUNDATION et al.) 13 November 2013 (2013-11-13)<br>See claims 1-26. | 1-8 |
| A | WO 2008-041560 A1 (KABUSHIKI KAISHA KOBE SEIKO SHO) 10 April 2008 (2008-04-10)<br>See claims 1-17. | 1-8 |
| A | JP 2009-054421 A (SUMITOMO LIGHT METAL IND LTD. et al.) 12 March 2009 (2009-03-12)<br>See claims 1-9. | 1-8 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 February 2023** | **10 February 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2022/017131**

| Patent document cited in search report | | | Publication date (day/month/year) | Patent family member(s) | | | Publication date (day/month/year) |
|---|---|---|---|---|---|---|---|
| KR | 10-2011-0020106 | A | 02 March 2011 | AU | 2010-284790 | A1 | 15 March 2012 |
| | | | | BR | 112012003731 | A2 | 30 June 2020 |
| | | | | CA | 2771696 | A1 | 24 February 2011 |
| | | | | CN | 102484261 | A | 30 May 2012 |
| | | | | EP | 2469634 | A2 | 27 June 2012 |
| | | | | JP | 2013-501340 | A | 10 January 2013 |
| | | | | JP | 5734291 | B2 | 17 June 2015 |
| | | | | MX | 2012002218 | A | 19 June 2012 |
| | | | | RU | 2012112361 | A | 10 October 2013 |
| | | | | RU | 2521077 | C2 | 27 June 2014 |
| | | | | SG | 178849 | A1 | 27 April 2012 |
| | | | | US | 2012-0148941 | A1 | 14 June 2012 |
| | | | | US | 8778566 | B2 | 15 July 2014 |
| | | | | WO | 2011-021881 | A2 | 24 February 2011 |
| KR | 10-0964131 | B1 | 16 June 2010 | CA | 2460841 | A1 | 27 March 2003 |
| | | | | KR | 10-2004-0035820 | A | 29 April 2004 |
| | | | | US | 2004-0247978 | A1 | 09 December 2004 |
| | | | | US | 2009-0293262 | A1 | 03 December 2009 |
| | | | | WO | 03-026052 | A1 | 27 March 2003 |
| KR | 10-2013-0124071 | A | 13 November 2013 | KR | 10-1491752 | B1 | 11 February 2015 |
| WO | 2008-041560 | A1 | 10 April 2008 | CN | 101517799 | A | 26 August 2009 |
| | | | | EP | 2068389 | A1 | 10 June 2009 |
| | | | | JP | 2008-210773 | A | 11 September 2008 |
| | | | | JP | 2010-045038 | A | 25 February 2010 |
| | | | | JP | 4551429 | B2 | 29 September 2010 |
| | | | | JP | 5022419 | B2 | 12 September 2012 |
| | | | | KR | 10-1086535 | B1 | 23 November 2011 |
| | | | | KR | 10-2009-0052886 | A | 26 May 2009 |
| | | | | TW | 200836395 | A | 01 September 2008 |
| | | | | US | 2010-0151358 | A1 | 17 June 2010 |
| JP | 2009-054421 | A | 12 March 2009 | JP | 5132224 | B2 | 30 January 2013 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020150138105